# EUROPÄISCHE PATENTSCHRIFT

(11) **EP 1 765 921 B1**
(45) Veröffentlichungstag und Bekanntmachung des Hinweises auf die Patenterteilung: **28.05.2008**
(21) Anmeldenummer: 05756057.5
(22) Anmeldetag: 16.06.2005
(51) Int. Cl.: C08J 7/04, B05D 7/00, B32B 7/02

(54) **MULTILAGENSCHICHTAUFBAU FÜR POLYMERE**
MULTILAYER STRUCTURE FOR POLYMERS
STRUCTURE MULTICOUCHE DESTINEE A DES POLYMERES

(30) Priorität: 02.07.2004 DE 102004032013
(43) Veröffentlichungstag der Anmeldung: 28.03.2007
(73) Patentinhaber: REHAU AG + Co, 95111 Rehau (DE)
(72) Erfinder: SCHETTLER, Thomas, 95111 Rehau (DE); QUANDT, Edgar, 95185 Gattendorf (DE)
(86) Internationale Anmeldenummer: PCT/EP2005/006440
(87) Internationale Veröffentlichungsnummer: WO 2006/002768

(56) Entgegenhaltungen:
- WO-A-03/102056
- WO-A-20/04069904
- DE-A1- 19 901 834

## Beschreibung

Die Erfindung betrifft einen Multilagen-Schichtaufbau, insbesondere geeignet zur Kratzschutzversiegelung und Metalldekorveredelung topographisch definierter Polymeroberflächen, sowie die vakuumtechnischen Verfahren zum Aufbau der Schichtfolge.

### Stand der Technik

Aufgrund der stets anwachsenden Anforderungen an die ästhetische (Glanz, Farbe) als auch funktionelle (Kratzschutz, Schlagfestigkeit) Erscheinung von Oberflächen geformter Teile, insbesondere auch im Bereich der Formteile aus Kunststoffen, wird seit langem an der Verbesserung der bekannten aber auch teilweise unzureichenden Beschichtungen für Kunststoffe gearbeitet. Diese Beschichtungen müssen, wie vorstehend bereits angedeutet, mehrere Funktionen erfüllen und dabei gleichzeitig gut am beschichteten Formteil haften und sehr widerstandsfähig sein.

Die im Stand der Technik bekannten Beschichtungsverfahren und Beschichtungen umfassen beispielsweise nasschemische Verfahren, wie Galvanotechnik, aber auch Vakuumtechniken, wie PVD-Verfahren (Physical Vapour Deposition). Derartige Verfahren werden auch zur Beschichtung von Formteilen eingesetzt.

So offenbart die DE 195 23 442 A1 Verfahren zur Beschichtung von Gegenständen aus Metall oder Metall-Legierungen, wobei eine Beschichtung durch ein CVD-Verfahren (Chemical Vapour Deposition) abgelagert wird. Dabei wird eine Schutzschicht auf dem Formteil durch Ablagerung einer quarzartigen Beschichtung erzeugt. Dazu wird ein reaktionsfähiges Gasgemisch, umfassend Sauerstoff und eine organische Silizium enthaltende Verbindung, durch eine elektrische Gasentladungsreaktion zu einer quarzartigen Beschichtung umgesetzt.

Die DE 199 01 834 A1 offenbart ein mehrstufiges Beschichtungsverfahren zur Aufbringung von verschiedenen Schichten auf Kunststoffsubstraten. Dabei werden Schichten, wie Unterschichten, Sperrschichten, Kratzschutzschichten und Gleitschichten, durch Umsetzung von Sauerstoff mit siliziumorganischen Verbindungen erzeugt. Die dafür beschriebenen Verfahren sind Vakuumverfahren, die die Erzeugung eines Plasmas umfassen.

Weiterhin offenbart die WO 2004/069904 A1 einen wasserspreitenden, kratzfesten und selbstreinigenden Kunststoffkörper, der dadurch erhältlich ist, dass man auf ein Kunststoffsubstrat eine Siloxan-Beschichtung aufbringt und aushärtet, den polaren Anteil der Oberflächenenergie der ausgehärteten Siloxan-Beschichtung auf einen Wert von mindestens 10 mN/m erhöht und eine photokatalytisch aktive TiO₂-Partikel enthaltende Beschichtung aufbringt und aushärtet und eine wasserspreitende, anorganische Beschichtung aufbringt und aushärtet.
Die einzelnen Schichten werden in flüssiger Form aufgetragen und in der Wärme getrocknet.

Einen vergleichbaren Ansatz zum vorstehend zitierten Schutzrecht lehrt die Schrift WO 03/102056 A1, die einen selbstreinigenden Kunstsfoffkörper beschreibt, der ebenso in einem Flüssigbeschichtungsverfahren der geschilderten Art erhältlich ist.

Die Nachteile der bekannten Verfahren und die Vorteile des erfindungsgemäßen Verfahrens bzw. der erfindungsgemäßen Beschichtung sind folgend kurz zusammengefasst.

### 1. Galvanotechnische Beschichtungsverfahren

Aufgrund der sehr unterschiedlichen Verfahrenstechniken (Vakuumbeschichtungstechnik im Vergleich zu nasselektrolytischer Beschichtungstechnik) weist das im Rahmen dieser Anmeldung beschriebene Verfahren einige sehr gravierende - und sich in der Regel als Vorteil erweisende - Unterschiede zur Galvanotechnik auf. Beispielhaft sind zu nennen die deutlich geringere Umweltgefährdung, die größere Flexibilität hinsichtlich abgeschiedener Metalle und die problemlosere Maskierung und Strukturierung.

### 2. Vakuum-Beschichtungsverfahren

Mit Hilfe moderner Vakuumbeschichtungsverfahren (wie z.B. der PVD- und CVD-Technologien) gelingt die Herstellung einer Vielzahl von Schichten und Schichtsystemen, die in der Lage sind, an der Oberfläche der beschichteten Körper eine Aufwertung herbeizuführen. Die Anwendungsinteressen können dabei z.B. in einer Verschleiß- und Reibungsminderung begründet sein oder auch in der dekorativen Aufwertung der Oberflächen oder Kombinationen davon. Da aber die vorliegende Erfindung nicht auf Silizium enthaltende Schichten beschränkt ist, ermöglicht die vorliegende Erfindung eine größere Bandbreite an Material- und Schichtkombinationen.

Die Durchsicht einschlägiger Fachliteratur lässt erkennen, dass sich die Anwendung harter, beanspruchungsfähiger Schichten bzw. Schichtsystemen (es sind dies Hartstoffbeschichtungen, im wesentlichen Nitride, Karbide, Karbonitride, Oxide von Metallen oder Metalllegierungen) überwiegend auf den Anwendungsbereich der Werkzeug- und Maschinentechnik - also auf metallische Substrate - erstreckt.
Siehe hierzu: Klaus W. Mertz, Hermann A. Jehn, Praxishandbuch moderne Beschichtungen, Carl Hanser 2001, Kapitel 1.2, 1.3 Tribologische Schichten.

Bezüglich der Anwendung der Vakuumbeschichtungsverfahren auf Kunststoffteile wird in derselben Quelle schwerpunktmäßig auf die Erzeugung von Schichten mit optischen, dekorativen und elektrischen Funktionen verwiesen. Im Hinblick auf die Erzeugung kratzfester Versiegelungen auf transparenten polymeren Materialien existieren Verfahrenspatente zur Bildung von SiOx-Verbindungen.

Die Kombinationen von Hartstoffschichten im Verbund mit polymeren Werkstoffen sind aufgrund des zu erwartenden Kontrasts im Eigenschaftsprofil (Härte, Plastizität, thermischer Ausdehnungskoeffizient) bisher grundsätzlich als problematisch anzusehen.

Aus Markus Riester, Berichte aus der Chemie, Titannitrid auf Thermoplasten, Shaker Verlag, 1998, Seite 17, Probenübersicht, Seite 64, Rissbildung, geht hervor, dass bei der Absetzung von Hartstoffschichten (hier TiN oder Ti/TiN - Multilayerschichtsystemen (2 bis 6 Doppellagen)) auf sehr glatten Oberflächen von Polymeren bereits ab einem Schichtdickenniveau von 0,06 µm eine hohe Neigung zur Rissbildung beim Schichtaufbau besteht.

### Aufgabenstellung

Aus dem genannten Stand der Technik ergibt sich die Aufgabenstellung, einen Schichtaufbau zur Verfügung zu stellen, welcher folgende Schichteigenschaften ermöglicht:
- metallisches Aussehen
- rissfreie Oberfläche
- hohe Randhärte, Abriebfestigkeit und Kratzfestigkeit
- schlagzähe Oberfläche
- hohe Haftfestigkeit der Schicht auf dem Substrat
- Schichtaufbau ohne Beeinflussung der Oberflächentopografie
- chemische Beständigkeit, insbesondere Korrosionsbeständigkeit.

Weiterhin ist ein Beschichtungsverfahren zur Verfügung zu stellen, das die Herstellung des gewünschten Schichtaufbaus gewährleistet und sich auszeichnet durch:
- umweltfreundlicher Verfahrenstechnik
- wirtschaftliche Herstellung durch Integration aller Verfahrensschritte in ein und dieselbe Verfahrensumgebung.

### Kurze Beschreibung der vorliegenden Erfindung

Die vorliegende Aufgabe konnte gelöst werden durch einen Schichtaufbau nach Anspruch 1. Bevorzugte Ausgestaltungen sind in den Unteransprüchen definiert. Weiterhin stellt die vorliegende Erfindung ein Verfahren zur Herstellung des Schichtaufbaus zur Verfügung, ebenso wie ein Kunststoffformteil, umfassend den erfindungsgemäßen Schichtaufbau. Bevorzugte Ausführungen und Weiterbildungen finden sich jeweils in den Unteransprüchen.

### Detaillierte Beschreibung der Erfindung

Die Erfindung beruht auf der Erkenntnis, dass die Berücksichtigung folgender Faktoren für die Lösung der Aufgabe wesentlich ist:
- Sichere Verankerung der Schicht bzw. des Schichtsystems auf dem polymeren Substrat
- Verträglichkeit der einzelnen Hauptschichten untereinander, insbesondere hinsichtlich thermischer Ausdehnungskoeffizient, Haftung, Härte und Flexibilität
- Gegebenenfalls Einbringung von Zwischenschichten, welche einen zu großen Eigenschaftssprung der Hauptschichten so überbrücken, dass der Schichtverbund selbst und seine Haftung auf dem polymeren Substrat auch bei thermischer oder mechanischer Belastung nicht versagen.

Erfindungsgemäß umfasst der Schichtaufbau die folgenden Hauptschichten (vom Kunststoffsubstrat ausgehend):
I Stützschicht, auf Basis SiOx
II Hartstoff-Mehrschichtenverbund auf Basis einer Multilayerbeschichtung
III farbgebende Metall- oder Metallverbindungsschicht.

In Abhängigkeit vom polymeren Substrat, den angestrebten Eigenschaften des Schichtverbundes und den sich daraus ergebenden Eigenschaften der jeweiligen Hauptschichten sind fallweise zusätzlich optionale Zwischenschichten vorgesehen.

Erfindungsgemäß kann sich durch die Einbringung optionaler Zusatzschichten in Form von Zwischenschichten und / oder Funktionalisierungsschichten ein Schichtaufbau ergeben, wie er nachfolgend aufgeführt ist.

| **Schichtzone** | | **Dickenbereich** |
|---|---|---|
| 0 | polymeres Substrat | beliebig |
| Ia | Zwischenschicht auf Basis einer funktionellen | |
| | Polymerschicht (optional) | max. 1000 nm |
| I | Stützschicht auf Basis von SiOx | max. 10000 nm |
| IIa | Zwischenschicht auf Basis Metall, Metallverbindung, | |
| | Polymerisationsschicht (optional) | max. 1000 nm |
| II | Hartstoff-Mehrschichtenverbund auf Basis einer | |
| | Multilayerbeschichtung | max. 2000 nm |
| IIIa | Zwischenschicht auf Basis Metall, Metallverbindung, | |
| | Polymerisationsschicht (optional) | max. 1000 nm |
| III | farbgebende Deckschicht auf Basis eines Metalls oder einer | |
| | Metallverbindung | max. 1000 nm |
| IIIb | Funktionalisierungschicht (optional) | max. 5000 nm |

Durch die erfindungsgemäße Kombination an Hauptschichten I bis III und die optionale Einbringung von Zusatzschichten Ia, IIa, IIIa und der Funktionalisierungsschicht IIIb stellt die vorliegende Erfindung ein System zur Erzeugung und Aufbringung von Beschichtungen auf polymeren Substraten zur Verfügung, das universell eingesetzt werden kann und das die Aufbringung von gewünschten Schichtkombinationen auf einer großen Vielzahl an unterschiedlichen Substraten ermöglicht. Durch die Einbringung der zusätzlichen, optionalen Zwischenschichten lassen sich auch Schichtkombinationen erzeugen, die bislang aufgrund der unterschiedlichen Materialeigenschaften (s.o., z.B. unterschiedliche Expansionskoeffizienten, daher Gefahr der Rissbildung) nicht denkbar schienen. Da die vorliegende Erfindung die maßgeblichen Einflussfaktoren für die Probleme im Stand der Technik identifiziert hat (Haftvermögen, Härte, Flexibilität, thermische Ausdehnungskoeffizienten), kann das Beschichtungssystem der vorliegenden Erfindung variabel viele Material- und Schichtkombinationen zur Verfügung stellen, da insbesondere durch die Einbringung der optionalen Zwischenschichten ein Ausgleich für ggf. problematische Materialeigenschaften gefunden werden kann. Dabei wird die Einbringung von optionalen Zwischenschichten immer dann vorgenommen, wenn die Werte für ausgewählte Material- und Schichteigenschaften für zwei benachbarte Hauptschichten (Haftvermögen, Härte, Flexibilität, thermische Ausdehnungskoeffizienten) zu weit voneinander abweichen. Die Einbringung der optionalen Zwischenschichten ermöglicht hier erfindungsgemäß einen Ausgleich bzw. eine graduelle Anpassung der Eigenschaften, so dass eine problemlose Schichtabfolge möglich wird.

### 0: Polymeres Substrat

Das erfindungsgemäß einzusetzende polymere Substrat ist im Hinblick auf die Materialauswahl, Schichtdicke und Form nicht beschränkt. Erfindungsgemäß können alle Kunststoffmaterialien eingesetzt werden, insbesondere die Kunststoffe, die im technischen Bereich weit verbreitet Verwendung finden, wie Polycarbonate, Polyamide, Polyolefine, Polyester, o.ä., insbesondere Polycarbonate.

Die Dicke der polymeren Substrate-und-ihre-Form ist ebenfalls nicht beschränkt, obwohl Dicken von mehr als einigen Millimetern aus thermischen Gründen bevorzugt sind. Die polymeren Substrate können insbesondere bevorzugt in einem Spritzgussverfahren hergestellt werden, obwohl auch andere Formgebungsverfahren, wie die Extrusion, die Kalt- und Warmverformung, das Tiefziehen und Kombinationen daraus möglich sind. Das polymere Substrat kann nur eine Schicht oder mehrere Schichten umfassen, wobei auch Materialkombinationen Verwendung finden können. Das polymere Substrat kann auch Hilfsstoffe usw. umfassen, wie Füllstoffe oder Verstärkungsstoffe, wie Glasfasern.

Die Oberflächenausgestaltung des polymeren Substrats ist ebenfalls nicht beschränkt. Glatte Oberflächen wie auch raue Oberflächen können eingesetzt werden, ebenso wie Oberflächen mit einer spezifischen Formausgestaltung, z.B. Vertiefungen, Erhebungen, etc. Das erfindungsgemäße Verfahren ermöglicht auch bei derartigen Oberflächen eine sichere und haltbare Aufbringung der gewünschten Schichten, so dass der gewünschte Schutzeffekt bzw. Dekoreffekt erreicht wird, ohne dass die Oberflächenstrukturierung verloren geht.

### Ia: Zwischenschicht

Aufgabe der optionalen Zwischenschichtzone ist es, die Haftung zwischen dem polymeren Substrat und der siliziumoxidischen Stützschicht I zu verbessern.
Bei der Zwischenschicht kann es sich um die Grenzfläche des polymeren Substrats handeln, die durch Anlagerung von funktionellen Gruppen (z.B. Hydroxyl-, Carboxyl- und/oder Aminogruppen) modifiziert wurde. Als typisches Verfahren ist hierfür beispielhaft die Oberflächenaktivierung durch Behandlung mit einem Sauerstoffplasma zu nennen. Weiterhin kann als Zwischenschicht das Polymerisat von Monomeren, die wiederum funktionelle Gruppen tragen, fungieren. Hier ist beispielhaft die Plasmapolymerisation von funktionellen Monomeren, wie Allylalkohol, Acrylsäure oder Allylamin, anzuführen. Auch eine Plasmabeschichtung mit Hexamethyldisiloxan (HMDSO) bei geringer Sauerstoffeinbindung und hohem organischen Anteil (SiOx-Schicht mit x < 1,6, bevorzugt x < 1,5) kann eine Haftungsverbesserung bewirken.

Die in diesem Zusammenhang einzusetzenden Verfahren und die jeweilige Prozesssteuerung kann der Fachmann, basierend auf den Informationen der nachfolgenden Beispiele, bestimmen oder durch orientierende Versuche erkennen. Geeignet ist insbesondere eine Zwischenschicht, erhältlich durch Niederdruckplasmapolymerisation von HMDSO.

Die Dicke dieser Zwischenschicht Ia beträgt üblicher Weise 0,1 bis 1000 nm, wobei Dicken im Bereich von bis zu 100 nm bevorzugt sind.

Diese optionale Zwischenschicht wird dann eingesetzt, wenn die Haftung zwischen Stützschicht und polymerem Substrat zu gering ist.

### I: Stützschicht

Die Stützschicht I dient insbesondere der Bereitstellung einer funktionalisierten Oberfläche, so dass die nachfolgende Hartstoffschicht sicher auf dem polymeren Substrat aufgebracht werden kann. Bevorzugt ist für die Stützschicht eine Dicke von 100 bis 10000 nm, wobei Dicken bis 6000 nm in den meisten Fällen ausreichend sind. Diese Schicht umfasst als konstituierenden Bestandteil bevorzugt ein SiOₓ-System, wobei x bevorzugt 1,4 bis 2 beträgt. Daneben kann die Stützschicht noch weitere, anorganische oder organische Bestandteile umfassen, solange die Funktion und die Schichtintegrität dadurch nicht beeinträchtigt wird.

### Aufbau

Neben organischen Bestandteilen besteht diese Schicht vornehmlich aus Silizium und Sauerstoff (SiOx), wobei typischerweise 1,4 bis 2 Sauerstoffatome auf ein Siliziumatom entfallen (SiO_{1,4} bis SiO₂). Durch zusätzliche Zufuhr von Sauerstoffgas (O₂) bei der Herstellung kann der Sauerstoffanteil in der Schicht erhöht werden, bis hin zu einer Quarzähnlichen Schicht mit x annähernd 2.

Erfindungsgemäß wird die Stützschicht bevorzugt gradient oder mehrlagig aufgebaut. Substratseitig sollte mit einem geringeren Sauerstoffanteil (x ~ 1,4) begonnen werden, um eine möglichst gute Haftung zu erzielen.

Der Sauerstoffanteil ist dann zu steigern (vorzugsweise bis x nahe 2), um die Härte der Schicht zu erhöhen und die Eigenschaften denen der Hartstoffschicht II anzupassen, so dass auch hier eine gute Haftung gesichert wird. Der Bereich für die Variable x ist dabei in vielen Ausführungsformen von 1,4 bis 2, wobei auch der Bereich von 1,7 bis 1,9 bzw. von 1,75 bis 1,85 ausreichend ist, um die gewünschte Funktion zu erfüllen. Diese Schicht ist bevorzugt dadurch gekennzeichnet, dass sich die Variable x entweder kontinuierlich (gradienter Aufbau) oder schrittweise (mehrlagiger Aufbau) ändert, wobei die oben angeführte Regel eingehalten wird (substratseitig ist x kleiner als außen). Dies kann durch geeignete Verfahrensführung erreicht werden, insbesondere durch kontinuierliche oder schrittweise Veränderung des Sauerstoffanteils im Reaktionsgas. Die Dicke der einzelnen Schichten bei einer mehrlagigen Struktur ist dabei nicht beschränkt, solange die gewünschte Gesamtdicke erreicht wird. Die einzelnen Schichten bei der mehrlagigen Struktur sind aber typischerweise sehr ähnlich. Geeignet sind insbesondere Schichten, erhältlich durch Niederdruckplasmapolymerisation von HMDSO mit variierenden Anteilen von Sauerstoff, z.B. bis zu einem Mischungsverhältnis von 60 Volumen-Prozent HMDSO und 40 Volumen-Prozent O₂.

### Herstellung

Die Stützschicht wird bevorzugt mit einem Verfahren der Plasma-unterstützten chemischen Gasphasenabscheidung (PECVD, Plasma Enhanced Chemical Vapour Deposition) erzeugt. Die Moleküle des Monomergases werden unter dem Einfluss des Plasmas fragmentiert, sie polymerisieren dann auf den in die Plasmakammer eingebrachten Substraten.

Unter Vakuumbedingungen (Prozessdruck zwischen 0,001 mbar und 100 mbar, vorzugsweise zwischen 0,01 und 10 mbar) wird ein siliziumhaltiges Monomergas (z.B. Hexamethyldisiloxan (HMDSO), Hexamethyldisilazan (HMDSN), Tetraethylorthosilikat (TEOS)) durch Einkopplung elektrischer Energie (z.B. in Form von radiofrequenter Strahlung oder Mikrowellenstrahlung) in die Plasmaphase überführt, so dass ein Gemisch aus Monomeren, Monomerfragmenten, Molekülen, Atomen, Ionen und Elektronen vorliegt.

Die dem Plasmagas zugeführte elektrische Energie liegt hierbei typischerweise in einem Bereich von wenigen Hundert bis zu einigen Tausend Watt.

Durch Zufuhr von leicht ionisierbaren Gasen (z.B. Argon, Xenon)-kann die Plasmazündung, die Plasmahomogenität und die Plasmastabilität unterstützt werden. Durch die Einbringung von zusätzlichem Sauerstoff kann weiterhin die chemische Zusammensetzung der Schicht so gesteuert werden, dass insbesondere auch der gewünschte Gradient für die Variable x erreicht werden kann.

### IIa: Zwischenschicht

Analog zu Ia übernimmt die optionale Zwischenschicht IIa haftvermittelnde Funktionen zum Aufbau der Folgeschichten. Die Zwischenschicht IIa kann als Metallschicht zur Anwendung kommen, bestehend z.B. aus Aluminium (AI) oder Kupfer (Cu) oder Cobalt (Co) oder Eisen (Fe) oder Nickel (Ni) oder Titan (Ti) oder Hafnium (Hf) oder Vanadium (V) oder Niob (Nb) oder Tantal (Ta) oder Chrom (Cr) oder Molybdän (Mo) oder Wolfram (W) oder Zirkon (Zr) oder Lanthan (La) oder Thorium (Th) oder aus einer Mischzusammensetzung der vorgenannten Metalle oder als Metallverbindungsschicht, z.B. Titandioxid (TiO₂), Titancarbid (TiC), Titannitrid (TiN), Titanoxinitrid (TiON), Titancarbonitrid (TiCN), oder als Reaktionsprodukt von Plasmapolymerisationsprozessen, z.B. Diamond-like-Carbon-Schichten (DLC-Schichten), siehe auch die Ausführungen unter Ia. Die Dicke liegt typischerweise im Bereich von 0 bis 100 nm, wobei Dicken bis zu 50 nm häufig ausreichend sind.

### Aufbau

Die zum Aufbau einer Zwischenschicht IIa erforderliche Schichtdicke beträgt max. 1000 nm. Bevorzugt ist die Zwischenschicht IIa eine Metallschicht aus Al, Cu, Co, Fe, Ni, Ti, Hf, V, Nb, Ta, Cr, Mo, W, oder einer Mischzusammensetzung davon, oder eine auf Titan (TiO₂, TiC, TiN, TiON, TiCN) basierende Schicht. Geeignet ist insbesondere eine Metallschicht, bevorzugt eine Titanschicht, erhältlich durch Sputtern, wie beispielsweise DC-Magnetron-Sputtern.

### Herstellung

Die zur Herstellung wirksamer Haftvermittlerschichten eingesetzte Schichtbildungstechnologie orientiert sich an den prozesstechnischen Gegebenheiten, die für den Aufbau der Basis- und Folgeschichen installiert sind.

Geeignet sind Plasmaverhren (siehe Ia, oben) aber auch Metallabscheidungsverfahren, wie Sputtern. Weiterhin wird hier auf die nachfolgenden Beschreibungen unter I Stützschicht - Herstellung und II Hartstoffschicht - Herstellung verwiesen. Da es bei der Auswahl der Dicke und des Materials für die Zwischenschicht IIa entscheidend auf die Materialien der umgebenden (benachbarten) Schichten ankommt, kann hier keine exakte Regel für die Auswahl der Materialien und Herstellungsverfahren gegeben werden.

### II: Hartstoff-Mehrschichtenverbund

Die Hartstoffschicht II dient insbesondere als Schutzschicht gegenüber mechanischer Beeinträchtigung, insbesondere als Kratzschutzschicht sowie zur Verankerung eines Farbmerkmals für die Oberfläche. Die Dicke dieser Schicht liegt typischerweise im Bereich von 20 bis 2000 nm, wobei häufig Dicken im Bereich von bis zu 600 nm oder 700 nm ausreichend sind.

### Aufbau

Die Hartstoffschicht stellt eine Kombination einer Vielzahl von Einzelschichten (Multilayer) dar, die auf Basis einer Kombination
a. eines Metalles, ausgewählt aus Kobalt (Co) oder Titan (Ti) oder Hafnium (Hf) oder Vanadium (V) oder Niob (Nb) oder Tantal (Ta) oder Chrom (Cr) oder Molybdän (Mo) oder Wolfram (W) oder Zirkon (Zr) oder Lanthan (La) oder Thorium (Th) und / oder einer Mischzusammensetzung und / oder einer Legierung der genannten Metalle mit
b. einer Hartstoffverbindung, ausgewählt aus Titanoxid (TiO₂) oder Titanborid (TiB₂) oder Titancarbid (TiC) oder Titannitrid (TiN) oder Titancarbonitrid (TiCN) oder Zirkonborid (ZrB₂) oder Zirkoncarbid (ZrC) oder Zirkonnitrid (ZrN) oder Vanadiumborid (VB₂) oder Vanadiumcarbid (VC) oder Vanadiumnitrid (VN) oder Niobborid (NbB₂) oder Niobcarbid (NbC) oder Niobnitrid (NbN) oder Tantalborid (TaB₂) oder Tantalcarbid (TaC) oder Chromborid (CrB₂) oder Chromcarbid (Cr₃C₂) oder Chromnitrid (CrN) oder Molybdänborid (Mo₂B₅) oder Molybdäncarbid (Mo₂C) oder Wolframborid (W₂B₅) oder Wolframcarbid (WC) oder Lanthanborid (LaB₆) hergestellt werden. Die Zusammensetzung der Einzelschichten Enterscheidet sich dabei hinsichtlich des Anteils von N und / oder C und / oder O und / oder B.

Besonders bevorzugt ist der Aufbau der Hartstoffschicht aus Titan und / oder Titanlegierungen und boridischen, carbidischen, nitridischen, oxidischen und / oder carbonitridischen Titanverbindungen.

Silicide der unter a. genannten Metalle sind erfindungsgemäß ebenfalls geeignet, die Hartstoffschicht aufzubauen, diese eignen sich insbesondere für die Herstellung im Sputterprozess.

Verbindungen der oben unter b. genannten Art sind erfindungsgemäß besonders geeignet, als Hartstoffverbindungen zum Aufbau der Hartstoffschicht II eingesetzt zu werden.

Die Anordnung der Einzelschichten erfolgt - wie nachfolgend näher ausgeführt - in einer Art und Weise, die zu einem Minimum von Eigenspannungen im Schichtaufbau führt, was sich letztlich in der Rissfreiheit der erzeugten Schichten und in deren elastischen Eigenschaften makroskopisch wahrnehmbar mitteilt.

Folgende zwei architektonische Grundprinzipien definieren den Aufbau der erfindungsgemäßen Hartstoff-Multilayer-Schicht und sind dabei zu beachten:

### a) Symmetrieprinzip:

Die Symmetrie im Aufbau ist dergestalt, dass sich - ausgehend von einer mittleren Zone, die als reine Metall- oder Metalllegierungsschicht abgesetzt ist - sowohl zur Substratseite hin als auch zur Außenseite hin boridische, nitridische, karbidische oder karbonitridische oder oxidische oder oxinitridische Reaktionsverbindungsschichten der Metalle oder der Metalllegierung anschließen. Dabei ist die jeweilige chemische Zusammensetzung der sich entsprechenden Schichten im Multilayer-Verbund identisch, d.h. die der mittleren Schicht benachbarten Schichten gleichen sich, die jeweils auf beiden Seiten darauffolgenden Schichten gleichen sich, usw. Diese Ausgestaltung der Hartstoffschicht umfasst bevorzugt eine mittlere Metallschicht, die dicker ist als die anderen Schichten des Multilayer-Verbunds.

Die Anzahl der Gesamtschichten im Multilayer Verbund kann variabel gestaltet werden, bevorzugt sind jedoch 7 bis 99 Schichten, stärker bevorzugt 11 bis 49 Schichten. Die Schichtdicke für die mittlere metallische Schicht liegt dabei im Bereich von 50 bis 150 nm, bevorzugt im Bereich von 70 bis 100 nm, besonders bevorzugt bei etwa 90 nm. Die weiteren Schichten im Multilayer-Verbund sind jeweils deutlich dünner, bevorzugt sind hier Dicken im Bereich von 8 bis 25 nm, bevorzugt im Bereich von 10 bis 20 nm. Dabei weisen bevorzugt die sich jeweils entsprechenden Schichten (symmetrisch zur mittleren Schicht) sehr ähnliche Dicken auf.

### b) Gradientenprinzip:

Das Gradientenprinzip ist im Aufbau dergestalt verwirklicht, dass in der Schichtfolge der Multilayerstruktur zunächst ein bezüglich der Schichthärte abnehmender Gradient vorliegt und dann anschließend - ausgehend von einer rein metallischen Zwischenzone - wieder ein ansteigender Härtegradient. Dabei kann der Gradient durch entsprechende Reaktionsführung erzeugt werden.

### Herstellung

Für die Herstellung der Schichtzone II kommen vorzugsweise vakuumtechnische Verfahren in Betracht, wie
- kathodische und anodische Bogenverdampfung
- RF-Magnetron-Sputtertechnik
- unipolar und bipolar gepulste Magnetron-Sputtertechnik
- bipolar gepulste Dual-Magnetron-Sputtertechnik
- Strahlablationsverfahren
   (als Laserstrahlablationsverfahren und / oder Elektronenstrahlablationsverfahren)
- Elektronenstrahlverdampfung.

Die Erzeugung rein metallischer Schichten erfolgt unter Verwendung eines inerten Prozessgases, z.B. Argon und / oder Xenon. Zur Erzeugung von Metallverbindungsschichten (Hartstoffverbindungen boridischer, carbidischer, nitridischer, oxidischer und carbonitridischer Natur) werden nitridbildende und / oder karbidbildende und / oder oxidbildende und / oder boridbildende Gase der Prozessatmosphäre beigemischt. Die jeweils auszuwählenden Verfahren und Verfahrensparameter ergeben sich aufgrund der Informationen, die in dem nachfolgenden Ausführungsbeispiel genannt sind.

Geeignet zum Aufbau-einer carbidischen Verbindung sind insbesondere Gasgemische aus Argon (oder einem anderen Inertgas) und Stickstoff oder Sauerstoff und einer Kohlenstoffquelle, z.B. Methan. Dabei beträgt der Anteil an Inertgas typischerweise 85 bis 99 Volumen-Prozent.

### IIIa: Zwischenschicht

Analog zu Ia und IIa übernimmt die Zwischenschicht IIIa haftvermittelnde Funktionen zum Aufbau der Folgeschichten. Die Zwischenschicht IIIa kann als Metallschicht zur Anwendung kommen (z.B. Cr oder Ti) oder als Metallverbindungsschicht (z.B. TiO₂, TiC, TiN, TiON, TiCN) oder als Reaktionsprodukte von Plasmapolymerisationsprozessen (z.B. DLC-Schichten). Im Zusammenhang mit der Schicht IIIa wird auf die Ausführungen zu den Schichten la und IIa verwiesen, die hier analog für die Schicht IIIa gelten.

### Aufbau

Die zum Aufbau einer Zwischenschicht IIIa erforderliche Schichtdicke beträgt max. 1000 nm. Bevorzugt beträgt die Schichtdicke 1 bis 100 nm, wobei häufig auch Dicken von bis zu 70 oder 60 nm ausreichend sind.

### Herstellung

Die zur Herstellung wirksamer Haftvermittlerschichten eingesetzte Schichtbildungstechnik orientiert sich an den prozesstechnischen Gegebenheiten, die für den Aufbau der Basis- und Folgeschichen installiert sind. Siehe hierzu die Beschreibungen unter I Stützschicht - Herstellung, II Hartstoff-Mehrschichtenverbund - Herstellung und III Deckschicht - Herstellung. Bevorzugt sind auch hier Materialien auf Titanbasis, entweder als metallischer Werkstoff oder in der Form von TiO₂, TiC, TiN, TiON oder TiCN.

### III: Farbgebende Deckschicht:

Die farbgebende Deckschicht dient insbesondere dem Dekoreffekt, um dem polymeren Formteil (beschichtetem Substrat) eine gewünschte Farbe oder einen gewünschten Farbeffekt oder Glanz zu verleihen.

Sollte jedoch bereits die Hartstoffschicht II den gewünschten Farbton zur Verfügung stellen (insbesondere Multilayer-Verbundsysteme auf Basis von TiN können bereits gefärbt sein), so kann die Schicht III weggelassen werden. Die Dicke der Schicht 111 richtet sich nach den ausgewählten farbgebenden Materialien und den gewünschten Farbeffekten. Dicken im Bereich von 10 bis 1000 nm sind jedoch üblich, wobei häufig aber auch schon Dicken von 50 bis zu 500 nm ausreichend sind.

### Aufbau

Der sich aus den Aufbaustufen I bis II ergebende Farbton an der Oberfläche des Schichtaufbaus weist die der äußersten Randschicht entsprechende Farbe, nämlich einen Goldton auf, der für manche Anwendungsfälle bereits geeignet sein kann.

Zur Einstellung weiterer Farbtöne ist der Aufbau einer weiteren Schicht (farbgebende Deckschicht) erforderlich, die den Dekoreffekt im Hinblick auf einen bestimmten Zielfarbton bestimmt. Geeignet sind hierbei alle Metallbeschichtungen oder Metallverbindungsschichten von Metallen, die hinsichtlich ihrer Härte bzw. elastischen Eigenschaften in der Lage sind, das Aufbausystem zu ergänzen. Dazu sind insbesondere die üblichen Metalle und Metallverbindungen, wie Cr, Ti, TiC usw. geeignet.

Die hier relevanten Auswahlkriterien lassen sich wie folgt zusammenfassen:
- Die farbgebende Deckschicht muss eine mit dem Unterbau vergleichbare Härte bzw. Abriebbeständigkeit aufweisen, um eine dem Gesamtaufbau entsprechende Haltbarkeit aufzuweisen.
- Die farbgebende Deckschicht muss eine mit dem Unterbau vergleichbare Stabilität gegenüber Rissbildung aufweisen.

### Herstellung

Für die Herstellung der Schichtzone III kommen vorzugsweise vakuumtechnische Verfahren in Betracht wie:
- kathodische und anodische Bogenverdampfung
- RF-Magnetron-Sputtertechnik
- unipolar und bipolar gepulste Magnetron-Sputtertechnik
- bipolar gepulste Dual-Magnetron-Sputtertechnik
- Strahlablationsverfahren
   (als Laserstrahlablationsverfahren und / oder Elektronenstrahlablationsverfahren)
- Elektronenstrahlverdampfung.

Die Erzeugung rein metallischer Schichten erfolgt unter Verwendung eines inerten Prozessgases, zur Erzeugung von Metallverbindungsschichten werden nitridbildende und / oder karbidbildende und / oder oxidbildende und / oder boridbildende Gase der Prozessatmosphäre beigemischt. In diesem Zusammenhang wird auf die vorstehenden Ausführungen im Zusammenhang mit der Schicht II verwiesen.

### IIIb: Transparente Funktionsschicht:

Die optionale transparente Funktionsschicht kann als letzte Schicht aufgebracht werden. Ihre Dicke richtet sich nach der gewünschten Funktion und den dafür ausgewählten Materialien, sie beträgt jedoch typischerweise von 50 bis 500 nm. Durch diese letzte, abschließende Schicht kann noch eine zusätzliche Funktionalisierung erfolgen, z.B. hydrophile oder hydrophobe Ausgestaltung.

### Aufbau

Zur Verankerung weiterer wünschenswerter Funktionseigenschaften auf der Oberfläche des Schichtenaufbaus (z.B. Antifingerprint-Effekt, hydrophile oder hydrophobe Eigenschaften, selbstreinigende Funktionen) kann optional der Aufbau einer transparenten Deckschicht erfolgen, um die Gebrauchseigenschaften der Oberfläche zu verbessern.

### Herstellung

Für die Herstellung der Schichtzone IIIb kommen alle auf Metall- und Metallverbindungswerkstoffe adaptionsfähige Beschichtungssysteme in Frage, wenn sie den Farbeindruck der Oberfläche nicht wesentlich beeinflussen:
Beispiele hierfür sind:
- Sol-Gel-Verfahren
- PE-CVD-Beschichtungen (Plasma Enhanced Chemical Vapour Depsition)
- Pyrolytische Beschichtungen
- Adhäsiv wirksame Beschichtungssysteme auf der Basis von Suspensionen mit flourhaltigen Verbindungen
- Vakuumtechnisch erzeugte Schichten, umfassend
   - kathodische und anodische Bogenverdampfung
   - RF-Magnetron-Sputtertechnik
   - unipolar und bipolar gepulste Magnetron-Sputtertechnik
   - bipolar gepulste Dual-Magnetron-Sputtertechnik
   - Strahlablationsverfahren
      (als Laserstrahlablationsverfahren und / oder Elektronenstrahlablationsverfahren)
   - Elektronenstrahlverdampfung.

Die vorstehend beschriebenen Ausgestaltungen der vorliegenden Erfindung verdeutlichen, dass diese ein variabel einsetzbares Beschichtungssystem zur Verfügung stellt, das auf polymeren Substraten eine gewünschte Funktionalisierung und ästhetische Ausgestaltung ermöglicht, wobei die aufgebrachte Beschichtung sicher auf dem Substrat haftet und eine deutlich reduzierte Neigung zur Rissbildung zeigt. Die bei den jeweiligen Schichten beschriebenen Optionen zur Herstellung der jeweiligen Schicht verdeutlichen für den Fachmann auch die vielfältigen Optionen, das erfindungsgemäße Verfahren auszuführen, das in den Ansprüchen beschrieben ist. Die im Zusammenhang mit den jeweiligen Schichten beschriebenen bevorzugten Ausgestaltungen gelten ebenfalls für das erfindungsgemäße Kunststoffformteil und das erfindungsgemäße Verfahren zur Herstellung des Multilagenschichtaufbaus bzw. des Kunststoffformteils.

Das nachfolgende Ausführungsbeispiel (Tab. 1) illustriert die vorliegende Erfindung.

### Ausführungsbeispiel der Erfindung

Multilagenschichtaufbau auf Polycarbonat (PC) im Farbton silbern metallisch gemäß Tab. 1, angegeben sind Zusammensetzung, Schichtdicken und Verfahrensparameter zur Herstellung, die Schichten weisen folgenden Aufbau auf:

| | |
|---|---|
| 0 | polymeres Substrat |
| I a | Zwischenschicht auf Basis SiOx, wobei x= 1,4-1,6 |
| I | Stützschicht auf Basis von SiOx, wobei x = 1,75-1,85 |
| II a | Zwischenschicht auf Basis Ti |
| II | flexible Hartstoffschicht auf Basis Titannitrid (symmetrischer Aufbau, 21 Schichten) |
| III | farbgebende Deckschicht auf Basis Titankarbid |

**Tab. 1**

| | | | Schichtdicke | Herstellverfahren | Schichtbildungsbedingungen | | | | | | | |
|---|---|---|---|---|---|---|---|---|---|---|---|---|
| | | | | | Prozessgase | | Druck | Beschicht.- quelle | Abstand Substrat | Leistungsdaten | | Prozesszeit |
| | | | | | (Vol.-%) | | (µBar) | | (mm) | (kW) | (V) | (s) |
| 0 | Polymer | PC | 3mm- Platte | Spritzguss | - | | - | - | - | - | - | - |
| Ia | Zwischenschicht | SiOx | 0,5 µm | Mikrowellen- Niederdruck- plasma | HMDSO: | 100 | 100 | MW-Linearquelle 2,45 GHz | 100 | 2 | - | 30 |
| I | Stütz- | SiOx | 5µm | Mikrowellen- | HMDSO: | 60 | 100 | MW-Linear | 100 | 2 | - | 300 |
| | schicht | | | Niederdruck- plasma | O₂ : | 40 | | quelle 2,45 GHz | | | | |
| II a | Zwischenschicht | Ti | 30 nm | DC- Magnetron- Sputtem | Ar: | 100 | 2,5 | DC- Magnetron | 100 | 0,5 | 450 | 20 |
| II | Hartstoffschicht | TiN | 10 nm | DC- | Ar: | 90 | 2,6 | DC- | 100 | 0,5 | 474 | 15 |
| | | (10) | | Magnetron- Sputtern | N₂: | 10 | | Magnetron | | | | |
| | | TiN (9) | 13 nm | DC- | Ar: | 91 | 2,5 | DC- | 100 | 0,5 | 466 | 20 |
| | | | | Magnetron- Sputtern | N₂: | 9 | | Magnetron | | | | |
| | | TiN (8) | 15 nm | DC- | Ar: | 92 | 2,5 | DC- | 100 | 0,5 | 459 | 25 |
| | | | | Magnetron- Sputtem | N₂: | 8 | | Magnetron | | | | |
| | | TiN (7) | 19 nm | DC- | Ar: | 93 | 2,5 | DC- | 100 | 0,5 | 459 | 30 |
| | | | | Magnetron- Sputtern | N₂: | 7 | | Magnetron | | | | |
| | | TiN (6) | 20 nm | DC- | Ar: | 94 | 2,5 | DC- | 100 | 0,5 | 460 | 30 |
| | | | | Magnetron- Sputtern | N₂: | 6 | | Magnetron | | | | |
| | | TiN (5) | 20 nm | DC- | Ar: | 95 | 2,4 | DC- | 100 | 0,5 | 461 | 30 |
| | | | | Magnetron- Sputtern | N₂: | 5 | | Magnetron | | | | |
| | | TiN (4) | 20 nm | DC- | Ar: | 96 | 2,4 | DC- | 100 | 0,5 | 460 | 30 |
| | | | | Magnetron- Sputtern | N₂: | 4 | | Magnetron | | | | |
| | | TiN (3) | 19 nm | DC- Magnetron- Sputtem | Ar: N₂: | 97 3 | 2,4 | DC- Magnetron | 100 | 0,5 | 457 | 30 |
| | | TiN (2) | 20 nm | DC- | Ar | 98 | 2,4 | DC- | 100 | 0,5 | 450 | 30 |
| | | | | Magnetron- Sputtern | N₂: | 2 | | Magnetron | | | | |
| | | TiN (1) | 19 nm | DC- | Ar: | 99 | 2,4 | DC- | 100 | 0,5 | 443 | 30 |
| | | | | Magnetron- Sputtern | N₂: | 1 | | Magnetron | | | | |
| | | Ti | 90 nm | DC- Magnetron- Sputtern | Ar: | 100 | 2,4 | DC- Magnetron | 100 | 0,5 | 432 | 60 |
| | | TiN (1) | 20 nm | DC- | Ar: | 99 | 2,4 | DC- | 100 | 0,5 | 421 | 30 |
| | | | | Magnetron- Sputtem | N₂: | 1 | | Magnetron | | | | |
| | | TiN (2) | 20 nm | DC- | Ar: | 98 | 2,4 | DC- | 100 | 0,5 | 442 | 30 |
| | | | | Magnetron- Sputtern | N₂: | 2 | | Magnetron | | | | |
| | | TiN (3) | 19 nm | DC- | Ar: | 97 | 2,4 | DC- | 100 | 0,5 | 457 | 30 |
| | | | | Magnetron- Sputtern | N₂: | 3 | | Magnetron | | | | |
| | | TiN (4) | 19 nm | DC- | Ar: | 96 | 2,4 | DC- | 100 | 0,5 | 463 | 30 |
| | | | | Magnetron- Sputtern | N₂: | 4 | | Magnetron | | | | |
| | | TiN (5) | 19 nm | DC- | Ar: | 95 | 2,4 | DC- | 100 | 0,5 | 464 | 30 |
| | | | | Magnetron- Sputtern | N₂: | 5 | | Magnetron | | | | |
| | | TiN (6) | 20 nm | DC- | Ar: | 94 | 2,5 | DC- | 100 | 0,5 | 462 | 30 |
| | | | | Magnetron- Sputtern | N₂: | 6 | | Magnetron | | | | |
| | | TiN (7) | 20 nm | DC- | Ar: | 93 | 2,5 | DC- | 100 | 0,5 | 458 | 30 |
| | | | | Magnetron- Sputtern | N₂: | 7 | | Magnetron | | | | |
| | | TiN (8) | 15 nm | DC- | Ar: | 92 | 2,5 | DC- | 100 | 0,5 | 456 | 25 |
| | | | | Magnetron- Sputtern | N₂: | 8 | | Magnetron | | | | |
| | | TiN (9) | 13 nm | DC- | Ar: | 91 | 2,5 | DC- | 100 | 0,5 | 454 | 20 |
| | | | | Magnetron- Sputtern | N₂ : | 9 | | Magnetron | | | | |
| | | TiN | 10 nm | DC- | Ar: | 90 | 2,5 | DC- | 100 | 0,5 | 452 | 15 |
| | | (10) | | Magnetron- Sputtern | N₂: | 10 | | Magnetron | | | | |
| III | Deck- | TiC | 88 nm | DC- | Ar: | 94 | 2,7 | DC- | 100 | 0,5 | 444 | 120 |
| | schicht | | | Magnetron- Sputtern | CH₄: | 6 | | Magnetron | | | | |

TiN (i) mit i = 1 bis 10 charakterisiert die TiN-Schicht anhand der Prozessgaszusammensetzung, beispielsweise beträgt für i = 4 der Anteil N₂ im Prozessgas 4 Volumen-Prozent, der Anteil Ar dem gemäß 96 Volumen-Prozent.

### Schichteigenschaften

### Schichtenanalyse:

Zur Kontrolle der im Aufbauprozess zustande kommenden Schichten werden oberflächenorientierte Analyseverfahren und Mikrohärtemessungen nach Martens herangezogen.
Um Einflüsse von darunter liegenden Schichten auf die Analyseergebnisse auszuschließen, können die Analysen an Schichten vorgenommen werden, die um ein oder zwei Größenordnungen dicker produziert sind, als sie im Multilagenverbund vorliegen. Im Falle des Hartstoff-Mehrschichtensystems, aufgebaut aus TiN besteht ein Zusammenhang zwischen dem Farbton und dem Gehalt an Stickstoff in der Metallverbindungsschicht TiN, so dass auf diese Art und Weise das Zustandekommen des gradienten Aufbaus visuell nachvollziehbar ist.
Der Nachweis zum weitgehenden Erhalt der topografischen Merkmale der beschichteten Polymeroberfläche erfolgt über vergleichende REM-Untersuchungen.

### Qualifizierungskriterien:

Die Qualifizierung bezüglich optischer, mechanischer, thermischer und chemischer Anforderungen an das Schichtensystem erfolgt unter folgenden Kriterien:
- Farbcharakterisierung über Spektralanalyse
- Thermische Beständigkeit:
   - Temperaturwechselbeständigkeit DIN 53496 A
   - Temperaturwechselbeständigkeit 110°C / 1h
   - Thermoschockbeständigkeit 3 x 100 °C H₂O /18 °C H₂O
- Bewitterungsfähigkeit
   - Sonnenlichtsimulation DIN 75220
- Mechanischer Stress
   - Kugelfalltest m=1 kg, H=500 mm, T=-30 °C
   - Kratzfestigkeit nach Erichsensen 435, F=10N
   - Multisteinschlagfestigkeit DIN 55996-1
   - Chemikalienbeständigkeit DIN 53449 T3
   - Korrosionsbeständigkeit DIN 50021-CASS.

Das erfindungsgemäße Ausführungsbeispiel zeigt, dass eine ausgezeichnete Beschichtung durch die vorliegende Erfindung auf beispielsweise einem Polycarbonatsubstrat abgelagert werden kann. Die erfindungsgemäße Beschichtung erfüllt die Anforderungen an Härte, Haltbarkeit, Flexibilität und Stabilität.

Mit dem erfindungsgemäßen Verfahren zur Herstellung eines Multilagenschichtaufbaus können auch geformte Substrate aus Polymermaterial, wie beispielsweise Türeinstiegskanten, Embleme, Dekorteile, Bedienelemente und Abdeckungen im Bereich Automobilbau, Kantenbänder, Profile, Dekorteile und Abdeckungen im Bereich Möbel, Küche, Büro, Bad, mit Polymermaterial auf der Innenseite ausgekleidete Fittinge, Abdeckungen, Bedienelemente und Dekorteile an Geräten für die Datenverarbeitung und im Bereich Consumer Electronics, Fensterprofile an der Außenseite und der Innenseite, hohle Formteile auf der Außen- und der Innenoberfläche, hergestellt im Extrusionsverfahren, beschichtet werden.

## Patentansprüche

1. Multilagenschichtaufbau für polymere Substrate, umfassend eine Stützschicht (I), eine Hartstoffschicht (II) und eine Deckschicht (III), wobei die Stützschicht Silizium enthaltende Verbindungen umfasst und die Hartstoffschicht Metall enthaltende Verbindungen umfasst.

2. Multilagenschichtaufbau nach Anspruch 1, wobei die Hartstoffschicht (II) als Multilayer-Verbund ausgestaltet ist.

3. Multilagenschichtaufbau nach Anspruch 2, wobei der Multilayer-Verbund ausgewählt ist unter Multilayer-Verbundsystemen nach dem Symmetrieprinzip und Multilayer-Verbundsystemen nach dem Gradientenprinzip.

4. Multilagenschichtaufbau nach Anspruch 3, wobei das Multilayer-Verbundsystem nach dem Symmetrieprinzip insgesamt 11 bis 99 Schichten umfasst, mit einer etwa in der Mitte des Multilagenschichtaufbaus angeordneten Metall- oder Metalllegierungsschicht, wobei das Metall oder die Metalllegierung ausgewählt ist aus: Kobalt oder Titan oder Hafnium oder Vanadium oder Niob oder Tantal oder Chrom oder Molybdän oder Wolfram oder Zirkon oder Lanthan oder Thorium oder einer Kombination davon.

5. Multilagenschichtaufbau nach Anspruch 3, wobei das Multilayer-Verbundsystem aus einer oder mehreren Verbindungen, gebildet aus den Metallen oder Metalllegierungen gemäß Anspruch 4, besteht.

6. Multilagenschichtaufbau nach einem der vorstehenden Ansprüche, wobei die Stützschicht (I) ein Material der Zusammensetzung SiOₓ umfasst, wobei x von 1,4 bis 2 beträgt.

7. Multilagenschichtaufbau nach Anspruch 6, wobei sich die Zusammensetzung des Materials SiOₓ schrittweise oder kontinuierlich oder diskontinuierlich verändert mit zunehmendem Stöchiometrie-Wert x in Richtung auf die Hartstoffschicht (II).

8. Multilagenschichtaufbau nach einem der vorstehenden Ansprüche, weiter umfassend eine Zwischenschicht (Ia) angeordnet zwischen polymerem Substrat (0) und Stützschicht (I).

9. Multilagenschichtaufbau nach einem der vorstehenden Ansprüche, weiter umfassend eine Zwischenschicht (IIa) zwischen der Stützschicht (I) und der Hartstoffschicht (II).

10. Multilagenschichtaufbau nach einem der vorstehenden Ansprüche, weiter umfassend eine Zwischenschicht (IIIa) zwischen der Hartstoffschicht (II) und der Deckschicht (III).

11. Multilagenschichtaufbau nach einem der vorstehenden Ansprüche, weiter umfassend eine Funktionalisierungsschicht (IIIb) auf der Deckschicht (III).

12. Multilagenschichtaufbau nach einem der vorstehenden Ansprüche, wobei die Dicke der Stützschicht (I) maximal 10000 nm beträgt.

13. Multilagenschichtaufbau nach einem der vorstehenden Ansprüche, wobei die Dicke der Hartstoffschicht (II) maximal 2000 nm beträgt.

14. Multilagenschichtaufbau nach einem der vorstehenden Ansprüche, wobei die Dicke der Deckschicht (III) maximal 1000 nm beträgt.

15. Multilagenschichtaufbau nach einem der vorstehenden Ansprüche, wobei die Deckschicht (III) eine Titanverbindung umfasst.

16. Multilagenschichtaufbau nach Anspruch 15, wobei die Titanverbindung ein TiO₂ und/oder ein TiC und / oder ein TiN und / oder ein TiON und / oder ein TiCN ist.

17. Multilagenschichtaufbau nach Anspruch 9, wobei die Zwischenschicht (IIa) aus Aluminium (AI) oder Kupfer (Cu) oder Cobalt (Co) oder Eisen (Fe) oder Nickel (Ni) oder Titan (Ti) oder Hafnium (Hf) oder Vanadium (V) oder Niob (Nb) oder Tantal (Ta) oder Chrom (Cr) oder Molybdän (Mo) oder Wolfram (W) oder Zirkon (Zr) oder Lanthan (La) oder Thorium (Th) oder aus einer Mischzusammensetzung der vorgenannten Metalle oder aus einer Metallverbindungsschicht oder aus einem Reaktionsprodukt von Plasmapolymerisationsprozessen, z.B. Diamond-like-Carbon-Schichten (DLC-Schichten) aufgebaut ist.

18. Multilagenschichtaufbau nach Anspruch 17, wobei die Metallverbindungsschicht TiO₂ oder TiC oder TiN oder TiON oder TiCN ist.

19. Multilagenschichtaufbau nach Anspruch 9 oder 17, wobei die Zwischenschicht (IIa) eine Dicke von maximal 1000 nm aufweist.

20. Multilagenschichtaufbau nach Anspruch 8, wobei die Zwischenschicht (I) eine Dicke von maximal 1000 nm aufweist.

21. Multilagenschichtaufbau nach Anspruch 10, wobei die Zwischenschicht (IIIa) eine Dicke von maximal 1000 nm aufweist.

22. Multilagenschichtaufbau nach Anspruch 11, wobei die Funktionalisierungsschicht (IIIb) eine Dicke von maximal 5000 nm aufweist.

23. Kunststoffformteil, umfassend ein polymeres Substrat und auf mindestens einer Oberfläche davon einen Multilagenschichtaufbau nach einem der vorstehenden Ansprüche.

24. Kunststoffformteil nach Anspruch 23, wobei das polymere Substrat ein Material umfasst, ausgewählt aus der Gruppe bestehend aus Polycarbonat, Polyamid, Polyester und Polyolefin.

25. Verfahren zur Herstellung eines Multilagenschichtaufbaus oder Kunststoffformteils nach einem der vorstehenden Ansprüche, umfassend die Stufen: (a) Erzeugung einer Stützschicht (I) durch ein PE-CVD-Verfahren (Plasma Enhanced Chemical. Vapour Deposition); (b) Erzeugung einer Hartstoffschicht (II) auf der Stützschicht (I) durch kathodische oder anodische Bogenverdampfung oder Sputtern; und (c) Erzeugung einer Deckschicht (III) auf der Hartstoffschicht (II) durch kathodische oder anodische Bogenverdampfung oder Sputtern.

26. Verfahren nach Anspruch 25, weiter umfassend die Stufen: (a') Erzeugung einer Zwischenschicht (Ia) zwischen Stützschicht (I) und polymerem Substrat (0); und/oder (b') Erzeugung einer Zwischenschicht (IIa) zwischen Stützschicht (I) und Hartstoffschicht (II); und/oder (c') Erzeugung einer Zwischenschicht (IIIa) zwischen Hartstoffschicht (II) und Deckschicht (III); und/oder (d') Erzeugung einer Funktionsschicht (IIIb) auf der Deckschicht (III).

27. Verfahren nach Anspruch 26, wobei die Zwischenschicht (Ia) durch eine Behandlung mit einem Sauerstoffplasma, durch Plasmapolymerisation funktioneller Monomere oder durch Plasmabeschichtung mit Silizium enthaltenden Verbindungen erzeugt wird.

28. Verfahren nach Anspruch 26, wobei die Zwischenschicht (IIa) durch PE-CVD, kathodische oder anodische Bogenverdampfung oder Sputtern erzeugt wird.

29. Verfahren nach Anspruch 26, wobei die Zwischenschicht (IIIa) durch PE-CVD, kathodische oder anodische Bogenverdampfung oder Sputtern erzeugt wird.

30. Verfahren nach Anspruch 26, wobei die Funktionsschicht (IIIb) durch Sol-Gel-Verfahren, PE-CVD, pyrolytische Verfahren, kathodische oder anodische Bogenverdampfung, Sputtern oder Adhesivbeschichtungsverfahren erzeugt wird.

31. Verfahren nach einem der Ansprüche 25 bis 30, wobei als Inertgas bei Plasmaverfahren Argon eingesetzt wird.

32. Verwendung des Verfahrens zur Herstellung eines Multilagenschichtaufbaus nach einem der Ansprüche 25 bis 31 zur Dekoration von Formkörpern aller Art.

33. Verwendung des Verfahrens zur Herstellung eines Multilagenschichtaufbaus nach einem der Ansprüche 25 bis 31 zur kratzfesten Beschichtung von oberflächlich beanspruchten Formkörpern.

## Claims

1. Multilayer structure for polymeric substrates, comprising a support layer (I), a hard material layer (II) and a covering layer (III), the support layer comprising silicon-containing compounds and the hard material layer comprising metal-containing compounds.

2. Multilayer structure according to Claim 1, the hard material layer (II) being in the form of a multilayer composite.

3. Multilayer structure according to Claim 2, the multilayer composite being selected from multilayer composite systems according to the symmetry principle and multilayer composite systems according to the gradient principle.

4. Multilayer structure according to Claim 3, the multilayer composite system according to the symmetry principle comprising altogether 11 to 99 layers, with a metal or metal alloy layer arranged approximately in the middle of the multilayer structure, the metal or the metal alloy being selected from: cobalt or titanium or hafnium or vanadium or niobium or tantalum or chromium or molybdenum or tungsten or zirconium or lanthanum or thorium or a combination thereof.

5. Multilayer structure according to Claim 3, the multilayer composite system consisting of one or more compounds formed from the metals or metal alloys according to Claim 4.

6. Multilayer structure according to any of the above claims, the support layer (I) comprising a material of the composition SiOₓ, x being 1.4 to 2.

7. Multilayer structure according to Claim 6, the composition of the material SiOₓ changing in stages or continuously or discontinuously with increasing stoichiometry values x in the direction of the hard material layer (II).

8. Multilayer structure according to any of the above claims, further comprising an intermediate layer (la) arranged between polymeric substrate (0) and support layer (I).

9. Multilayer structure according to any of the above claims, further comprising an intermediate layer (IIa) between the support layer (I) and the hard material layer (II).

10. Multilayer structure according to any of the above claims, further comprising an intermediate layer (IIIa) between the hard material layer (II) and the covering layer (III).

11. Multilayer structure according to any of the above claims, further comprising a functionalizing layer (IIIb) on the covering layer (III).

12. Multilayer structure according to any of the above claims, the thickness of the support layer (I) being not more than 10 000 nm.

13. Multilayer structure according to any of the above claims, the thickness of the hard material layer (II) being not more than 2000 nm.

14. Multilayer structure according to any of the above claims, the thickness of the covering layer (III) being not more than 1000 nm.

15. Multilayer structure according to any of the above claims, the covering layer (III) comprising a titanium compound.

16. Multilayer structure according to Claim 15, the titanium compound being a TiO₂ and/or a TiC and/or a TiN and/or a TiON and/or a TiCN.

17. Multilayer structure according to Claim 9, the intermediate layer (IIa) being composed of aluminium (Al) or copper (Cu) or cobalt (Co) or iron (Fe) or nickel (Ni) or titanium (Ti) or hafnium (Hf) or vanadium (V) or niobium (Nb) or tantalum (Ta) or chromium (Cr) or molybdenum (Mo) or tungsten (W) or zirconium (Zr) or lanthanum (La) or thorium (Th) or of a mixed composition of the above metals or of a metal compound layer or of a reaction product of plasma polymerization processes, e.g. diamond-like carbon layers (DLC layers).

18. Multilayer structure according to Claim 17, the metal compound layer being TiO₂ or TiC or TiN or TiON or TiCN.

19. Multilayer structure according to Claim 9 or 17, the intermediate layer (IIa) having a thickness of not more than 1000 nm.

20. Multilayer structure according to Claim 8, the intermediate layer (Ia) having a thickness of not more than 1000 nm.

21. Multilayer structure according to Claim 10, the intermediate layer (IIIa) having a thickness of not more than 1000 nm.

22. Multilayer structure according to Claim 11, the functionalizing layer (IIIb) having a thickness of not more than 5000 nm.

23. Shaped plastic article, comprising a polymeric substrate and, on at least one surface thereof, a multilayer structure according to any of the above claims.

24. Shaped plastic article according to Claim 23, the polymeric substrate comprising a material selected from the group consisting of polycarbonate, polyamide, polyester and polyolefin.

25. Method for the production of a multilayer structure or shaped plastic article according to any of the above claims, comprising the stages: (a) production of a support layer (I) by a PE-CVD method (plasma enhanced chemical vapour deposition); (b) production of a hard material layer (II) on the support layer (I) by cathodic or anodic arc vaporization or sputtering; and (c) production of a covering layer (III) on the hard material layer (II) by cathodic or anodic arc vaporization or sputtering.

26. Method according to Claim 25, further comprising the stages: (a') production of an intermediate layer (la) between support layer (I) and polymeric substrate (0); and/ or (b') production of an intermediate layer (IIa) between support layer (I) and hard material layer (II); and/or (c') production of an intermediate layer (IIIa) between hard material layer (II) and covering layer (III); and/or (d') production of a functional layer (IIIb) on the covering layer (III).

27. Method according to Claim 26, the intermediate layer (la) being produced by a treatment with an oxygen plasma, by plasma polymerization of functional monomers or by plasma coating with silicon-containing compounds.

28. Method according to Claim 26, the intermediate layer (IIa) being produced by PE-CVD, cathodic or anodic arc vaporization or sputtering.

29. Method according to Claim 26, the intermediate layer (IIIa) being produced by PE-CVD, cathodic or anodic arc vaporization or sputtering.

30. Method according to Claim 26, the functional layer (IIIb) being produced by sol-gel methods, PE-CVD, pyrolytic methods, cathodic or anodic arc vaporization, sputtering or adhesive coating methods.

31. Method according to any of Claims 25 to 30, argon being used as inert gas in plasma methods.

32. Use of the method for the production of a multilayer structure according to any of Claims 25 to 31 for the decoration of mouldings of all types.

33. Use of the method for the production of a multilayer structure according to any of Claims 25 to 31 for the scratch-resistant coating of mouldings subjected to surface stress.

## Revendications

1. Structure multicouches pour substrats polymères, qui comprend une couche de soutien (I), une couche de substance dure (II) et une couche de recouvrement (III), la couche de soutien comprenant des composés qui contiennent du silicium et la couche de substance dure comprenant des composés qui contiennent un métal.

2. Structure multicouches selon la revendication 1, dans laquelle la couche (II) de substance dure est configurée comme composite multicouches.

3. Structure multicouches selon la revendication 2, dans laquelle le système composite multicouches est sélectionné parmi les systèmes composites multicouches formés selon le principe de symétrie et les systèmes composites multicouches formés selon le principe du gradient.

4. Structure multicouches selon la revendication 3, dans laquelle le système composite multicouches formé selon le principe de symétrie comprend globalement de 11 à 99 couches avec une couche de métal ou d'alliage métallique disposée sensiblement au milieu de la structure multicouches, le métal ou l'alliage métallique étant sélectionnés parmi le cobalt, le titane, le hafnium, le vanadium, le niobium, le tantale, le chrome, le molybdène, le tungstène, le zirconium, le lanthane, le thorium et une combinaison de ceux-ci.

5. Structure multicouches selon la revendication 3, dans laquelle le système composite multicouches est constitué d'un ou de plusieurs composés formés des métaux ou des alliages de métaux selon la revendication 4.

6. Structure multicouches selon l'une des revendications précédentes, dans laquelle la couche de soutien (I) contient un matériau de composition SiOₓ où x est compris entre 1, 4 et 2.

7. Structure multicouches selon la revendication 6, dans laquelle la composition du matériau SiOₓ est modifiée par pas, de manière continue ou de manière discontinue, la valeur stoechiométrique x augmentant en direction de la couche (II) de substance dure.

8. Structure multicouches selon l'une des revendications précédentes, qui comprend en outre une couche intermédiaire (la) disposée entre le substrat polymère (0) et la couche de soutien (I).

9. Structure multicouches selon l'une des revendications précédentes, qui comprend en outre une couche intermédiaire (IIa) entre la couche de soutien (I) et la couche (II) de substance dure.

10. Structure multicouches selon l'une des revendications précédentes, qui comprend en outre une couche intermédiaire (IIIa) entre la couche (II) de substance dure et la couche de recouvrement (III).

11. Structure multicouches selon l'une des revendications précédentes, qui comprend en outre une couche de fonctionnalisation (IIIb) sur la couche de recouvrement (III).

12. Structure multicouches selon l'une des revendications précédentes, dans laquelle l'épaisseur de la couche de soutien (I) est d'au plus 10 000 nm.

13. Structure multicouches selon l'une des revendications précédentes, dans laquelle l'épaisseur de la couche (II) de substance dure est d'au plus 2 000 nm.

14. Structure multicouches selon l'une des revendications précédentes, dans laquelle l'épaisseur de la couche de recouvrement (III) est d'au plus 1 000 nm.

15. Structure multicouches selon l'une des revendications précédentes, dans laquelle la couche de recouvrement (III) contient un composé du titane.

16. Structure multicouches selon la revendication 15, dans laquelle le composé du titane est le TiO₂ et/ou le TiC et/ou le TiN et/ou le TiON et/ou le TiCN.

17. Structure multicouches selon la revendication 9, dans laquelle la couche intermédiaire (IIa) est constituée d'aluminium (Al), de cuivre (Cu), de cobalt (Co), de fer (Fe), de nickel (Ni), de titane (Ti), de hafnium (Hf), de vanadium (V), de niobium (Nb), de tantale (Ta), de chrome (Cr), de molybdène (Mo), de tungstène (W), de zirconium (Zr) de lanthane (La), de thorium (Th) ou d'une composition mixte desdits métaux, ou est constituée d'une couche de composé métallique ou d'un produit de réaction de processus de polymérisation assisté par plasma, par exemple de couches de carbone de type diamant (couches DLC).

18. Structure multicouches selon la revendication 17, dans laquelle la couche de composé métallique est en TiO₂, en TiC, en TiN, en TiON ou en TiCN.

19. Structure multicouches selon les revendications 9 ou 17, dans laquelle la couche intermédiaire (IIa) a une épaisseur d'au plus 1 000 nm.

20. Structure multicouches selon la revendication 8, dans laquelle la couche intermédiaire (la) a une épaisseur d'au plus 1 000 nm.

21. Structure multicouches selon la revendication 10, dans laquelle la couche intermédiaire (IIIa) a une épaisseur d'au plus 1 000 nm.

22. Structure multicouches selon la revendication 11, dans laquelle la couche de fonctionnalisation (IIIb) a une épaisseur d'au plus 5 000 nm.

23. Pièce moulée en matière synthétique qui comprend un substrat polymère et sur au moins une surface de ce dernier une structure multicouches selon l'une des revendications précédentes.

24. Pièce moulée en matière synthétique selon la revendication 23, dans laquelle le substrat polymère contient un matériau sélectionné dans l'ensemble constitué des polycarbonates, des polyamides, des polyesters et des polyoléfines.

25. Procédé de fabrication d'une structure multicouches ou d'une pièce moulée en matière synthétique selon l'une des revendications précédentes, qui comprend les étapes qui consistent à : (a) former une couche de soutien (I) par un procédé PE-CVD (dépôt chimique de vapeur renforcé par plasma), (b) former une couche (II) de substance dure sur la couche de soutien (I) par vaporisation cathodique ou anodique à l'arc ou par pulvérisation et (c) former une couche de recouvrement (III) sur la couche (II) de substance dure, par vaporisation cathodique ou anodique à l'arc ou pulvérisation.

26. Procédé selon la revendication 25, qui comprend en outre les étapes qui consistent à : (a') former une couche intermédiaire (la) entre la couche de soutien (I) et le substrat polymère (0), et/ou (b') former une couche intermédiaire (IIa) entre la couche de soutien (I) et la couche (II) de substance dure et/ou (c') former une couche intermédiaire (IIIa) entre la couche (II) de substance dure et la couche de recouvrement (III) et/ou (d') former une couche fonctionnelle (IIIb) sur la couche de recouvrement (III).

27. Procédé selon la revendication 26, dans lequel la couche intermédiaire (la) est formée par traitement à un plasma d'oxygène, par polymérisation assistée par plasma de monomères fonctionnels ou par revêtement assisté par plasma de composés qui contiennent du silicium.

28. Procédé selon la revendication 26, dans lequel la couche intermédiaire (IIa) est formée par PE-CVD, vaporisation cathodique ou anodique à l'arc ou pulvérisation.

29. Procédé selon la revendication 26, dans lequel la couche intermédiaire (IIIa) est formée par PE-CVD, vaporisation cathodique ou anodique à l'arc ou pulvérisation.

30. Procédé selon la revendication 26, dans lequel la couche fonctionnelle (IIIb) est formée par un procédé à sol-gel, par PE-CVD, par des procédés pyrolytiques, par vaporisation cathodique ou anodique à l'arc, par pulvérisation ou par un procédé de revêtement par un adhésif.

31. Procédé selon l'une des revendications 25 à 30, dans lequel on utilise de l'argon comme gaz inerte dans le procédé assisté par plasma.

32. Utilisation du procédé de fabrication d'une structure multicouches selon l'une des revendications 25 à 31 pour la décoration de corps moulés de tout type.

33. Utilisation du procédé de fabrication d'une structure multicouches selon l'une des revendications 25 à 31 pour le revêtement anti-rayures de corps moulés dont la surface est fortement sollicitée.
